# EUROPEAN PATENT APPLICATION

(11) **EP 2 779 237 A2**
(43) Date of publication of application: **17.09.2014**
(21) Application number: 14158271.8
(22) Date of filing: 07.03.2014
(51) Int. Cl.: H01L 25/065, H01L 21/98, H01L 23/31, H01L 21/56

(54) **A chip arrangement and a method for manufacturing a chip arrangement**

(30) Priority: 14.03.2013 US 201313802843
(71) Applicant: Intel Mobile Communications GmbH, 85579 Neubiberg (DE)
(72) Inventor: Meyer, Thorsten, 93053 Regensburg (DE)
(74) Representative: Rummler, Felix

(57) **Abstract**

A chip arrangement may include: a first semiconductor chip having a first side and a second side opposite the first side; a second semiconductor chip having a first side and a second side opposite the first side, the second semiconductor chip disposed at the first side of the first semiconductor chip and electrically coupled to the first semiconductor chip, the first side of the second semiconductor chip facing the first side of the first semiconductor chip; an encapsulation layer at least partially encapsulating the first semiconductor chip and the second semiconductor chip, the encapsulation layer having a first side and a second side opposite the first side, the second side facing in a same direction as the second side of the second semiconductor chip; and an interconnect structure disposed at least partially within the encapsulation layer and electrically coupled to at least one of the first and second semiconductor chips, wherein the interconnect structure may extend to the second side of the encapsulation layer.

## Description

### Technical Field

Various aspects relate to a chip arrangement and a method for manufacturing a chip arrangement.

### Background

In manufacturing integrated circuits (ICs), the ICs, which may also be referred to as chips or dies, may be packaged prior to distribution and/or integration with other electronic assemblies. This packaging may include encapsulating the chips in a material, and providing electrical contacts on the exterior of the package to provide an interface to the chip.

As the demand for greater capabilities and features of ICs increases, a plurality of chips may be stacked onto each other to form a single IC package. This process of stacking a plurality of chips onto each other may be referred to as die stacking, and the result may be referred to as a die stack. Die stacking may increase the number of chips that may be housed within a single IC package for a given footprint. Consequently, real estate on a printed circuit board may be conserved and/or a board assembly process may be simplified. Besides saving space, die stacking may result in better electrical performance of the device, since the shorter routing of interconnections between chips that are stacked onto each other may result in faster signal propagation and reduction in noise and cross-talk.

Whilst the above-identified features of a die stack may be advantageous, stacking a plurality of chips onto each other may reduce an area available on the die stack for electrical routing and/or interconnects between the plurality of chips of the die stack and, for example, a printed circuit board. This may, for example, increase a complexity of a design of an IC package having a die stack. New ways of stacking chips and/or packaging stacked chips may be needed.

### Summary

A chip arrangement is provided, which may include: a first semiconductor chip having a first side and a second side opposite the first side; a second semiconductor chip having a first side and a second side opposite the first side, the second semiconductor chip disposed at the first side of the first semiconductor chip and electrically coupled to the first semiconductor chip, the first side of the second semiconductor chip facing the first side of the first semiconductor chip; an encapsulation layer at least partially encapsulating the first semiconductor chip and the second semiconductor chip, the encapsulation layer having a first side and a second side opposite the first side, the second side facing in a same direction as the second side of the second semiconductor chip; and an interconnect structure disposed at least partially within the encapsulation layer and electrically coupled to at least one of the first and second semiconductor chips, wherein the interconnect structure may extend to the second side of the encapsulation layer.

A method for manufacturing a chip arrangement is provided, which may include: providing a first semiconductor chip having a first side and a second side opposite the first side; disposing a second semiconductor chip over the first side of the first semiconductor chip, the second semiconductor chip having a first side and a second side opposite the first side, the first side of the second semiconductor chip facing the first side of the first semiconductor chip, wherein the second semiconductor chip may be electrically coupled to the first semiconductor chip; forming an encapsulation layer to at least partially encapsulate the first and second semiconductor chips, the encapsulation layer having a first side and a second side opposite the first side, the second side of the encapsulation layer facing in a same direction as the second side of the second semiconductor chip; and forming an interconnect structure at least partially within the encapsulation layer, wherein the interconnect structure may be electrically coupled to at least one of the first and second semiconductor chips and extends to the second side of the encapsulation layer.

### Brief Description of the Drawings

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:
FIG. 1A and FIG. 1B show cross-sectional views of conventional chip arrangements including at least one first chip stacked over a second chip.
FIG. 2 shows a cross-sectional view of a chip arrangement.
FIG. 3 shows a cross-sectional view of a chip arrangement including a filling material disposed between a first semiconductor chip and a second semiconductor chip.
FIG. 4 shows a cross-sectional view of a chip arrangement including a third semiconductor chip.
FIG. 5 shows a cross-sectional view of a chip arrangement including at least one through-via and a metallization layer.
FIG. 6 shows a method for manufacturing a chip arrangement.
FIG. 7A to FIG. 7I show a process flow for a method for manufacturing a chip arrangement.

### Description

The following detailed description refers to the accompanying drawings that show, by way of illustration, specific details and aspects in which the invention may be practised. These aspects are described in sufficient detail to enable those skilled in the art to practice the invention. Other aspects may be utilized and structural, logical, and electrical changes may be made without departing from the scope of the invention. The various aspects are not necessarily mutually exclusive, as some aspects can be combined with one or more other aspects to form new aspects. Various aspects are described for structures or devices, and various aspects are described for methods. It may be understood that one or more (e.g. all) aspects described in connection with structures or devices may be equally applicable to the methods, and vice versa.

The word "exemplary" is used herein to mean "serving as an example, instance, or illustration". Any aspect or design described herein as "exemplary" is not necessarily to be construed as preferred or advantageous over other aspects or designs.

The word "over", used herein to describe forming a feature, e.g. a layer "over" a side or surface, may be used to mean that the feature, e.g. the layer, may be formed "directly on", e.g. in direct contact with, the implied side or surface. The word "over", used herein to describe forming a feature, e.g. a layer "over" a side or surface, may be used to mean that the feature, e.g. the layer, may be formed "indirectly on" the implied side or surface with one or more additional layers being arranged between the implied side or surface and the formed layer.

In like manner, the word "cover", used herein to describe a feature disposed over another, e.g. a layer "covering" a side or surface, may be used to mean that the feature, e.g. the layer, may be disposed over, and in direct contact with, the implied side or surface. The word "cover", used herein to describe a feature disposed over another, e.g. a layer "covering" a side or surface, may be used to mean that the feature, e.g. the layer, may be disposed over, and in indirect contact with, the implied side or surface with one or more additional layers being arranged between the implied side or surface and the covering layer.

The terms "coupled" and/or "electrically coupled" and/or "connected" and/or "electrically connected", used herein to describe a feature being connected to at least one other implied feature, are not meant to mean that the feature and the at least one other implied feature must be directly coupled or connected together; intervening features may be provided between the feature and at least one other implied feature.

Directional terminology, such as e.g. "upper", "lower", "top", "bottom", "left-hand", "righthand", etc., may be used with reference to the orientation of figure(s) being described. Because components of the figure(s) may be positioned in a number of different orientations, the directional terminology is used for purposes of illustration and is in no way limiting. It is to be understood that structural or logical changes may be made without departing from the scope of the invention.

Chips (which may also be referred to as "dies") may have to be packaged prior to distribution and/or integration with other electronic devices, such as circuit boards (e.g. printed circuit boards), other chips and/or other chip packages. Packaging a chip (or die) may include encapsulating the chip (or die) in a material (e.g. a plastic material), and providing electrical contacts (e.g. solder balls and/or bumps, for example micro-bumps) at a surface (e.g. an exterior surface) of the chip package.

At least one other chip may be connected (e.g. electrically connected) to the chip of the chip package via the electrical contacts (e.g. bumps, for example micro-bumps). For example, the chip package may be stacked (e.g. vertically stacked) over at least one other chip, and the at least one other chip may be connected (e.g. electrically connected) to the chip of the chip package via the electrical contacts (e.g. bumps, for example micro-bumps).

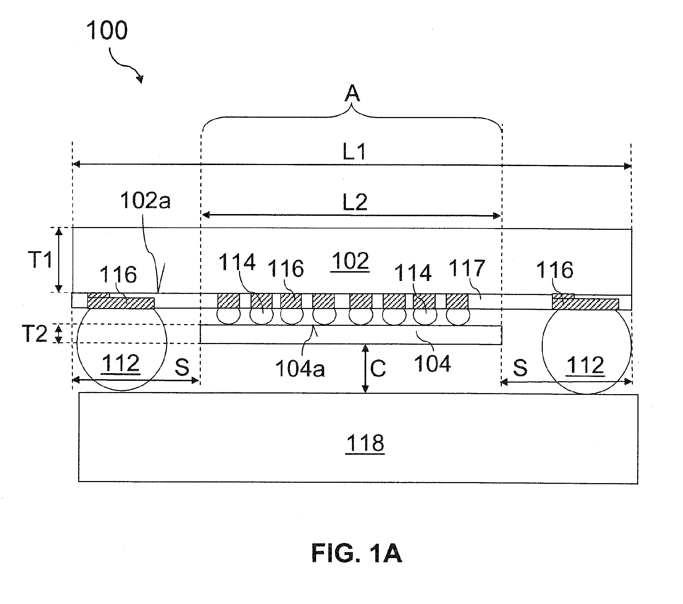

FIG. 1A shows a cross-sectional view of a conventional fan-in chip arrangement 100 including a first chip 102 stacked over a second chip 104.

The first chip 102 may include, or may be, a chip (or die) and/or a passive device (e.g. a resistor and/or capacitor and/or inductor).

The chip arrangement 100 may include a plurality of solder balls 112 and/or a plurality of bumps 114 (e.g. micro-bumps). The plurality of solder balls 112 and/or the plurality of bumps 114 (e.g. micro-bumps) may be formed at (e.g. disposed at) a side 102a of the first chip 102.

The first chip 102 may be electrically connected to at least one solder ball of the plurality of solder balls 112 and/or at least one bump of the plurality of bumps 114 by means of a redistribution layer (RDL) 116. The RDL 116 may, for example, be partially or fully disposed within an insulating layer 117 (e.g. a dielectric layer). The RDL 116 may redistribute and/or re-map electrical connections from the first chip 102 to the plurality of solder balls 112 and/or to the plurality of bumps 114.

The chip arrangement 100 may include a second chip 104, which may be arranged below the first chip 102. For example, the first chip 102 may be stacked over the second chip 104. The side 102a of the first chip 102 may be an active side 102a of the first chip 102, and the second chip 104 may have an active side 104a. The active side 102a of the first chip 102 may face the active side 104a of the second chip 104.

The first chip 102 may be coupled (e.g. electrically coupled) to the second chip 104, for example, via the plurality of bumps 114 (e.g. micro-bumps). For example, the active side 102a of the first chip 102 may be coupled (e.g. electrically coupled) to the active side 104a of the second chip 104. Since the active sides 102a, 104a of the first and second chips 102, 104 may face each other, the plurality of bumps 114 provided between the first chip 102 and the second chip 104 may have a short height.

The arrangement formed by the first chip 102 and the second chip 104 may be referred to as an mother-daughter die WLB (wafer level ball grid array) package. The first chip 102 may, for example, be referred to as a mother die or a carrier die, and the second chip 104 may be referred to as a daughter die. The first chip 102 (e.g. mother die) may, for example, carry the second chip 104 (e.g. daughter die) on its active side 102a. The second chip 104 (e.g. daughter die) may be smaller than the first chip 102 (e.g. mother die). For example, a lateral extent L2 of the second chip 104 (e.g. daughter die) may be smaller than a lateral extent L1 of the first chip 102 (e.g. mother die). By way of another example, a thickness T2 of the second chip 104 (e.g. daughter die) may be smaller than a thickness T1 of the first chip 102 (e.g. mother die).

The mother-daughter die WLB package shown in FIG. 1A may be electrically connected to a printed circuit board (PCB) 118, for example, via the plurality of solder balls 112. As shown in FIG. 1A, there may be a region A within the lateral extent L1 of the first chip 102 that may be occupied by the second chip 104 (e.g. daughter die). Since the region A of the first chip 102 may be occupied by the second chip 104, the plurality of solder balls 112 may not be formed at the region A. In a fan-in wafer level package where the plurality of solder balls 112 may be required to fit within the lateral extent L1 of the first chip 102 (e.g. mother die), occupation of the region A by the second chip 104 (e.g. daughter die) may limit the number of solder balls 112 that may be provided for the electrical connection between the first chip 102 (e.g. mother die) and the PCB 118.

Furthermore, the region A of the first chip 102 (e.g. mother die) may not be available for electrical routing since it is occupied by the second chip 104 (e.g. daughter die). In a fan-in wafer level package where the electrical routing may be required to fit within the lateral extent L1 of the first chip 102 (e.g. mother die), occupation of the region A by the second chip 104 (e.g. daughter die) may limit the area available for electrical routing. This may increase the design complexity of the mother-daughter die WLB package.

The second chip 104 (e.g. daughter die) may need to have a small lateral extent L2 in order to provide a space S around the second chip 104 (e.g. daughter die) in order to accommodate the plurality of solder balls 112. In a fan-in wafer level package where the electrical routing and/or the plurality of solder balls 112 may be required to fit within the lateral extent L1 of the first chip 102 (e.g. mother die), the space S may be limited. In turn, this may limit the size of the second chip 104 (e.g. daughter die) that may be used in an mother-daughter die WLB package.

The second chip 104 (e.g. daughter die) may need to be thinned to a desired thickness T2 in order to fit between the first chip 102 (e.g. mother die) and the PCB 118. For example, there may be a need to provide a clearance C between the second chip 104 (e.g. daughter die) and the PCB 118. Accordingly, the second chip 104 (e.g. daughter die) may need to be thinned prior to attaching it to the first chip 102 (e.g. mother die). Picking up a thinned second chip 104 (e.g. daughter die) and placing it at a side (e.g. active side 102a) of the first chip 102 (e.g. mother die) may be difficult.

A reflow process may be performed in order to connect the second chip 104 (e.g. daughter die) to the first chip 102 (e.g. via the plurality of bumps 114). It may be difficult to perform a reflow process on the thinned second chip 104 (e.g. daughter die). Furthermore, performing the reflow process on the second chip 104 (e.g. daughter die) with a small thickness T2 may decrease yield, thus increasing a cost of manufacturing the chip arrangement 100.

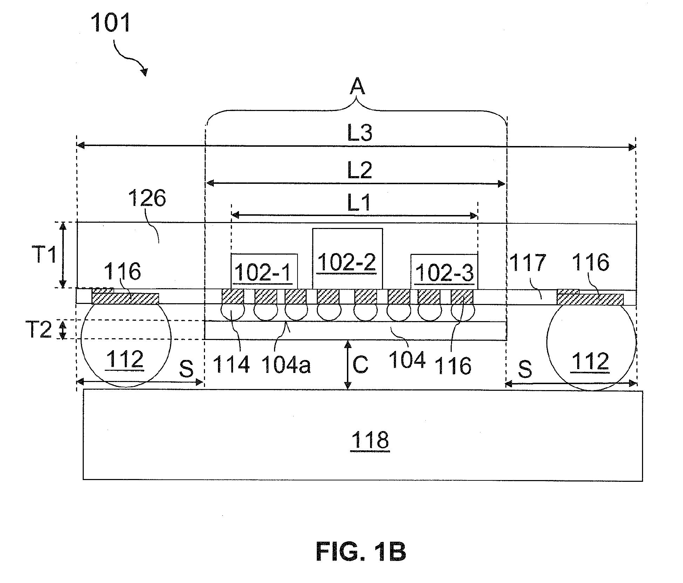

FIG. 1B shows a cross-sectional view of a conventional fan-out chip arrangement 101 including at least one first chip 102-1, 102-2, 102-3 stacked over a second chip 104.

Reference signs in FIG. 1B that are the same as in FIG. 1A denote the same or similar elements as in FIG. 1A. Thus, those elements will not be described in detail again here; reference is made to the description above. Differences between FIG. 1B and FIG. 1A are described below.

As shown in FIG. 1B, a fan-out chip arrangement 101 may include at least one first chip 102-1, 102-2, 102-3 embedded in an encapsulation 126. The RDL 116 may redistribute and/or re-map electrical connections from the at least one first chip 102-1, 102-2, 102-3 to the plurality of solder balls 112 and/or to the plurality of bumps 114.

In a fan-out chip arrangement, such as the chip arrangement 101, the plurality of solder balls 112 and/or to the plurality of bumps 114 may extend beyond the lateral extent L1 of the at least one first chip 102-1, 102-2, 102-3. Nonetheless, the region A of the lateral extent L3 of the chip arrangement 101 may not be available for electrical routing and/or for forming the plurality of solder balls 112 and/or the plurality of bumps 114 due to occupation of the region A by the second chip 104. In other words, a backside of the second chip 104 (e.g. daughter chip) may not be used for electrical routing and/or for forming the plurality of solder balls 112 and/or the plurality of bumps 114.

In view of the above-mentioned features of the fan-in chip arrangement 100 and the fan-out chip arrangement 101, the following needs may be identified:

There may be a need to provide a chip arrangement in which a daughter die does not limit the number of solder balls that may be provided for an electrical connection to or from a mother die, whilst preventing a large increase in the total size (e.g. total lateral extent) of a fan-out chip arrangement.

There may be a need to provide a chip arrangement in which an area available for electrical routing on a mother die is not limited by a presence of a daughter die.

There may be a need to provide a chip arrangement in which a plurality of solder balls may be formed at a side (e.g. a backside) of a daughter die.

There may be a need to provide a chip arrangement in which electrical routing may be formed at a side (e.g. a backside) of a daughter die.

There may be a need to provide a chip arrangement in which a daughter die may be thinned to a desired thickness after attaching it to a mother die.

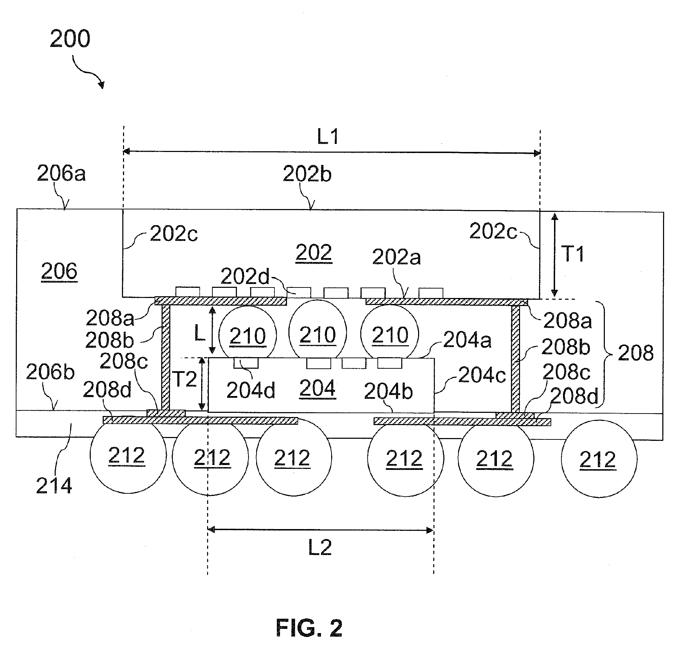

Such a chip arrangement may, for example, be provided by the chip arrangement shown in FIG. 2.

FIG. 2 shows a cross-sectional view of a chip arrangement 200.

The chip arrangement 200 may include a first semiconductor chip 202, a second semiconductor chip 204, an encapsulation layer 206, and an interconnect structure 208.

Only one first semiconductor chip 202 is shown as an example, however the number of first semiconductor chips 202 may be greater than one, and may, for example, be two, three, four, five, etc. For example, the chip arrangement 200 may include a plurality of first semiconductor chips 202, which may, for example, be arranged laterally adjacent to each other.

In like manner, only one second semiconductor chip 204 is shown as an example, however the number of second semiconductor chips 204 may be greater than one, and may, for example, be two, three, four, five, etc. For example, the chip arrangement 200 may include a plurality of second semiconductor chips 204, which may, for example, be arranged laterally adjacent to each other.

The first semiconductor chip 202 and/or the second semiconductor chip 204 may include, or may be, a chip (or die) for use in MEMS (micro-electromechanical systems) applications and/or logic applications and/or memory applications and/or power applications, although chips for use in other applications may be possible as well. The first semiconductor chip 202 and/or the second semiconductor chip 204 may include, or may be, a passive component (e.g. a resistor and/or capacitor and/or inductor).

The first semiconductor chip 202 and/or the second semiconductor chip 204 may include a semiconductor substrate, which may include, or may consist of, a semiconductor material. The semiconductor material may include, or may be, at least one material selected from a group of materials, the group consisting of: silicon, germanium, gallium nitride, gallium arsenide, and silicon carbide, although other materials may be possible as well.

The first semiconductor chip 202 may, for example, be a mother die (which may also be referred to as a carrier die). The second semiconductor chip 204 may, for example, be a daughter die that may, for example, be coupled (e.g. electrically coupled) to the first semiconductor chip 202 (e.g. mother die or carrier die).

The first semiconductor chip 202 may have a first side 202a and a second side 202b opposite the first side 202a. The first semiconductor chip 202 may further include at least one sidewall 202c. The first side 202a and the second side 202b of the first semiconductor chip 202 may include, or may be, a frontside and a backside of the first semiconductor chip 202, respectively. By way of another example, the first side 202a of the first semiconductor chip 202 may include, or may be, an active side of the first semiconductor chip 202. By way of yet another example, the first side 202a and the second side 202b of the first semiconductor chip 202 may include, or may be, a bottom surface and a top surface of the first semiconductor chip 202, respectively.

The second semiconductor chip 204 may have a first side 204a and a second side 204b opposite the first side 204a. The second semiconductor chip 204 may further include at least one sidewall 204c. The first side 204a and the second side 204b of the second semiconductor chip 204 may include, or may be, a frontside and a backside of the second semiconductor chip 204, respectively. By way of another example, the first side 204a of the second semiconductor chip 204 may include, or may be, an active side of the second semiconductor chip 204. By way of yet another example, the first side 204a and the second side 204b of the second semiconductor chip 204 may include, or may be, a bottom surface and a top surface of the second semiconductor chip 204, respectively.

The second semiconductor chip 204 may be disposed at the first side 202a (e.g. frontside) of the first semiconductor chip 202. For example, in the view shown in FIG. 2, the second semiconductor chip 204 may be disposed below the first side 202a (e.g. frontside) of the first semiconductor chip 202. In another view, for example, the second semiconductor chip 204 may be disposed over the first side 202a (e.g. frontside) of the first semiconductor chip 202.

The first semiconductor chip 202 and the second semiconductor chip 204 may be arranged in a face-to-face arrangement in the chip arrangement 200. For example, the first side 204a of the second semiconductor chip 204 may face the first side 202a of the first semiconductor chip 202, as shown in FIG. 2. As described above, the first side 202a of the first semiconductor chip 202 may be a frontside of the first semiconductor chip 202, and the first side 204a of the second semiconductor chip 204 may be a frontside of the second semiconductor chip 204. In such an example, the first semiconductor chip 202 and the second semiconductor chip 204 may be arranged in a frontside-to-frontside arrangement. By way of another example, the first side 202a of the first semiconductor chip 202 may be an active side of the first semiconductor chip 202, and the first side 204a of the second semiconductor chip 204 may be an active side of the second semiconductor chip 204. In such an example, the active sides of the first semiconductor chip 202 and the second semiconductor chip 204 may face each other.

The first semiconductor chip 202 may be larger than the second semiconductor chip 204. For example, the first semiconductor chip 204 may have a thickness T1, which may be measured in a direction perpendicular to the first surface 202a of the first semiconductor chip 202. The second semiconductor chip 204 may have a thickness T2, which may be measured in a direction perpendicular to the first surface 204a of the second semiconductor chip 204.

The first semiconductor chip 202 may be larger than the second semiconductor chip 204 in that the thickness T1 of the first semiconductor chip 202 may be larger than the thickness T2 of the second semiconductor chip 204. The thickness T2 of the second semiconductor chip 204 may, for example, be less than or equal to about 100 µm, for example less than or equal to about 75 µm, for example less than or equal to about 50 µm, for example less than or equal to about 20 µm, for example less than or equal to about 15 µm, although other thicknesses may be possible as well.

The first semiconductor chip 202 may have a lateral extent L1 which may be measured in a direction perpendicular to the thickness T1, and the second semiconductor chip 204 may have a lateral extent L2 which may be measured in a direction perpendicular to the thickness T2. The first semiconductor chip 202 may be larger than the second semiconductor chip 204 in that the lateral extent L1 of the first semiconductor chip 202 may be larger than the lateral extent L2 of the second semiconductor chip 204, as shown in FIG. 2. The lateral extent L1 may be a length of the first semiconductor chip 202, and the lateral extent L2 may be a length of the second semiconductor chip 204. Accordingly, the first semiconductor chip 202 may have a greater length than the second semiconductor chip 204.

The first semiconductor chip 202 may be larger than the second semiconductor chip 204 in that a chip area of the first semiconductor chip 202 may be larger than a chip area of the second semiconductor 204. A chip area may, for example, refer to an area of a side of the first semiconductor chip 202 and/or the second semiconductor chip 204. For example, an area of the first side 202a (e.g. active side) of the first semiconductor chip 202 may be larger than an area of the first side 204a (e.g active side) of the second semiconductor chip 204.

The second semiconductor chip 204, which may be smaller than the first semiconductor chip 202, may be disposed laterally within a boundary of the first semiconductor chip 202. For example, the lateral extent L2 of the second semiconductor chip 204 may be within the lateral extent L1 of the first semiconductor chip 202, as shown in FIG. 2. In other words, the first semiconductor chip 202 (e.g. a boundary of the first semiconductor chip 202) may extend laterally beyond the second semiconductor chip 204 (e.g. a boundary of the second semiconductor chip 204).

The first semiconductor chip 202 and the second semiconductor chip 204 may be coupled (e.g. electrically coupled) to each other. For example, the first semiconductor chip 202 may be integrated (e.g. vertically integrated) with the second semiconductor chip 204. The first semiconductor chip 202 and the second semiconductor chip 204 may be coupled (e.g. electrically coupled) to each other via, for example, at least one electrical connector (e.g. interconnect, e.g. chip interconnect) 210. In other words, the chip arrangement 200 may include at least one electrical connector (e.g. interconnect, e.g. chip interconnect) 210, which may couple (e.g. electrically couple) the first semiconductor chip 202 to the second semiconductor chip 204. The at least one electrical connector 210 may, for example, be disposed between the first side 202a (e.g. active side) of the first semiconductor chip 202 and the first side 204a (e.g. active side) of the second semiconductor chip 204, as shown in FIG. 2.

The first semiconductor chip 202 may include at least one electrically conductive contact 202d that may be disposed at the first side 202a (e.g. active side) of the first semiconductor chip 202. The at least one electrically conductive contact 202d may be coupled (e.g. electrically coupled) to the at least one electrical connector 210 disposed between the first side 202a (e.g. active side) of the first semiconductor chip 202 and the first side 204a (e.g. active side) of the second semiconductor chip 204. The first semiconductor chip 202 and the second semiconductor chip 204 may be coupled (e.g. electrically coupled) to each other via, for example, the at least one electrical connector 210. The at least one electrical connector 210 may, in turn, be coupled (e.g. electrically coupled) to at least one electrically conductive contact 202d that may be disposed at the first side 202a (e.g. active side) of the first semiconductor chip 202. The at least one electrical connector 210 may, for example, include or be at least one bump, or the like. The coupling (e.g. electrical coupling) between the at least one electrical connector 210 and the at least one electrically conductive contact 202d of the first semiconductor chip 202 may be a direct coupling (e.g. electrical coupling), or may include at least one intervening structure. The at least one intervening structure may include, or may be, a redistribution structure or a metallization (e.g. an under-bump metallization), although other intervening structures may be possible as well.

The second semiconductor chip 204 may include at least one electrically conductive contact 204d that may be disposed at the first side 204a (e.g. active side) of the second semiconductor chip 204. The at least one electrically conductive contact 204d may be coupled (e.g. electrically coupled) to the at least one electrical connector 210 disposed between the first side 202a (e.g. active side) of the first semiconductor chip 202 and the first side 204a (e.g. active side) of the second semiconductor chip 204. In other words, the first semiconductor chip 202 and the second semiconductor chip 204 may be coupled (e.g. electrically coupled) to each other via, for example, at least one electrical connector 210, which may, in turn, be coupled (e.g. electrically coupled) to at least one electrically conductive contact 204d that may be disposed at the first side 204a of the second semiconductor chip 204.

The at least one electrically conductive contact 202d of the first semiconductor chip 202 and/or the at least one electrically conductive contact 204d of the second semiconductor chip 204 may include, or may be, a pad (e.g. a bonding pad). The at least one electrically conductive contact 202d of the first semiconductor chip 202 and/or the at least one electrically conductive contact 204d of the second semiconductor chip 204 may, for example, provide an interface (e.g. an electrical interface) for the first semiconductor chip 202 and/or the second semiconductor chip 204, respectively. In other words, signals (e.g. electrical signals, power supply potentials, ground potentials, etc.) may be exchanged with the first semiconductor chip 202 and/or the second semiconductor chip 204 via the at least one electrically conductive contact 202d and/or the at least one electrically conductive contact 204d, respectively.

As described above, the first side 202a of the first semiconductor chip 202 may be a frontside of the first semiconductor chip 202, and the first side 204a of the second semiconductor chip 204 may be a frontside of the second semiconductor chip 204. In a face-to-face arrangement, a shorter interconnect may, for example, be possible between the first semiconductor 202 and the second semiconductor 204. In other words, a length L of the at least one electrical connector 210 disposed between the first side 202a of the first semiconductor chip 202 and the first side 204a of the second semiconductor chip 204 may be shorter.

The at least one electrical connector 210 may include, or may consist of, at least one electrically conductive material selected from a group of electrically conductive materials, the group consisting of: a metal or metal alloy. For example, the at least one electrical connector 210 may consist of a solder material (e.g. may contain tin, silver, nickel, conductive paste or copper or an alloy of one or more of the listed materials). By way of another example, the at least one electrical connector 210 may consist of copper, palladium, titanium, tungsten, nickel, gold, aluminum or a conductive paste or a stack or an alloy including or consisting of at least one of the listed metals.

The at least one electrical connector 210 may include, or may be, at least one of a bump and a pillar, although other electrical connectors may be possible as well. By way of an example, the at least one electrical connector 210 may include, or may be, a bump, for example, a solder bump and/or a micro-bump (e.g. micro solder bump) and/or a flip-chip bump. By way of another example, the at least one electrical connector 210 may include, or may be, a pillar bump (e.g. a metal-pillar bump, for example a copper-pillar bump).

The chip arrangement 200 may include an encapsulation layer 206. The encapsulation layer 206 may at least partially encapsulate the first semiconductor chip 202 and the second semiconductor chip 204. For example, the encapsulation layer 206 may enclose the second semiconductor chip 204 from at least one sidewall 204c and the first side 204a, and may enclose the first semiconductor chip 202 from at least one sidewall 202c and the first side 202a, as shown in FIG. 2.

The encapsulation layer 206 may have a first side 206a and a second side 206b opposite the first side 206a. The first side 206a of the encapsulation layer 206 may, for example, be a backside of the chip arrangement 200. The second side 206b of the encapsulation layer 206 may, for example, be a frontside of the chip arrangement 200.

The first side 206a of the encapsulation layer 206 may face in a same direction as the second side 202b (e.g. backside) of the first semiconductor chip 202. For example, as shown in FIG. 2, the first side 206a of the encapsulation layer 206 and the second side 202b (e.g. backside) of the first semiconductor chip 202 may face away from the first side 202a (e.g. frontside) of the first semiconductor chip 202. The first side 206a of the encapsulation layer 206 may be at least substantially flush with the second side 202b (e.g. backside) of the first semiconductor chip 202. In other words, the first side 206a of the encapsulation layer 206 and the second side 202b (e.g. backside) of the first semiconductor chip 202 may at least form a substantially flat surface of the chip arrangement 200, as shown in FIG. 2.

The second side 206b of the encapsulation layer 206 may face in a same direction as the second side 204b (e.g. backside) of the second semiconductor chip 204. For example, as shown in FIG. 2, the second side 206b of the encapsulation layer 206 and the second side 204b (e.g. backside) of the second semiconductor chip 204 may face away from the first side 202a of the first semiconductor chip 202. The second side 206b of the encapsulation layer 206 may be at least substantially flush with the second side 204b (e.g. backside) of the second semiconductor chip 204. In other words, the second side 206b of the encapsulation layer 206 and the second side 204b of the second semiconductor chip 204 may form an at least substantially flat surface of the chip arrangement 200, as shown in FIG. 2. Alternatively, the encapsulation layer 206 may cover the second side 204b (e.g. backside) of the second semiconductor chip 204.

The encapsulation layer 206 may include, or may consist of, a material that may be different from the first semiconductor chip 202 and the second semiconductor chip 204. The encapsulation layer 206 may include, or may consist of, an insulating material. The encapsulation layer 206 may include, or may consist of, a molding material (namely, a material that may be molded by means of a molding process). By way of another example, the encapsulation layer 206 may include, or may consist of, a laminate material (namely, a material that may be laminated by means of a lamination process).

The encapsulation layer 206 may include, or may consist of, at least one material selected from a group of materials, the group consisting of: a plastic material, a thermoplastic material, and a filler material (e.g. including, or consisting of, at least one of a silica filler, a glass filler, a glass cloth, rubber and metal particles), although other materials may be possible as well. By way of an example, the encapsulation layer 206 may include, or may consist of, a plastic material (e.g. an epoxy resin, such as, for example, a thermosetting molding compound). By way of another example, the encapsulation layer 206 may include, or may consist of, a plastic material (e.g. a thermoplastic, such as, for example, a high purity fluoropolymer).

The chip arrangement 200 may include an interconnect structure 208. The interconnect structure 208 may be disposed at least partially within the encapsulation layer 206, as shown in FIG. 2. For example, the interconnect structure 208 may include a part 208a, 208b that may be disposed within the encapsulation layer 206, and may include a part 208c, 208d that may be disposed outside the encapsulation layer 206.

The interconnect structure 208 may, for example, include, or may consist of, at least one electrically conductive material, e.g. at least one metal and/or metal alloy. The at least one electrically conductive material may be selected from a group of electrically conductive materials, the group consisting of: aluminum, tungsten, titanium, copper, nickel, palladium and gold or a conductive paste (polymer, filled with electrically conductive particles), although other electrically conductive materials may be possible as well.

The interconnect structure 208 may, for example, redistribute and/or re-map electrical connections from the first side 202a of the first semiconductor chip 202 and/or the first side 204a of the second semiconductor chip 204 to the second side 206b of the encapsulation layer 206. Accordingly, the interconnect structure 208 may, for example, extend to the second side 206b of the encapsulation layer 206.

The interconnect structure 208 may extend to the second side 206b of the encapsulation layer 206 from the first side 202a of the first semiconductor chip. For example, the interconnect structure 208 may include a part 208a that may be disposed between the first side 202a of the first semiconductor chip 202 and the first side 204a of the second semiconductor chip 204. Accordingly, the interconnect structure 208 may extend from between the first side 202a of the first semiconductor chip 202 and the first side 204a of the second semiconductor chip 204 to the second side 206b of the encapsulation layer 206. The part 208a of the interconnect structure 208 may include, or may be, a redistribution layer (RDL) disposed at the first side 202a of the first semiconductor chip 202. The part 208a (e.g. RDL) may be configured to redistribute and/or re-map electrical connections from the first side 202a of the first semiconductor chip 202 and/or the first side 204a of the second semiconductor chip 204 to the second side 206b of the encapsulation layer 206.

By way of another example, the interconnect structure 208 may include a part 208b that may extend from the first side 202a of the first semiconductor chip 202 to the second side 206b of the encapsulation layer 206. Accordingly, the interconnect structure 208 may extend from the first side 202a of the first semiconductor chip 202 to the second side 206b of the encapsulation layer 206. The part 208b of the interconnect structure 208 may include, or may be, at least one metal pillar extending from the first side 202a of the first semiconductor chip 202 to the second side 206b of the encapsulation layer 206. The part 208b (e.g. at least one metal pillar) of the interconnect structure 208 may be disposed laterally adjacent to the second semiconductor chip 204, and may be coupled (e.g. electrically coupled) to the part 208a (e.g. RDL) of the interconnect structure 208, as shown in FIG. 2.

The interconnect structure 208 may further extend over, for example, the second side 204b of the second semiconductor chip 204. For example, the interconnect structure 208 may include a part 208c, 208d that may be formed at the second side 204b of the second semiconductor chip 204, and may extend over the second side 204b of the second semiconductor chip 204, as shown in FIG. 2. The part 208c, 208d of the interconnect structure 208 may be coupled (e.g. electrically coupled) to the part 208b (e.g. at least one metal pillar) and to the part 208a (e.g. RDL). The part 208c, 208d of the interconnect structure 208 extending over the second side 204b of the second semiconductor chip 204 may, for example, be a redistribution layer (RDL) (e.g. a frontside RDL) that may redistribute and/or re-map electrical connections from the first side 202a of the first semiconductor chip 202 and/or the first side 204a of the second semiconductor chip 204 to the second side 204b of the second semiconductor chip 204.

The interconnect structure 208 may be coupled (e.g. electrically coupled) to the first semiconductor chip 202 and/or the second semiconductor chip 204. As described above, the first semiconductor chip 202 and the second semiconductor chip 204 may be coupled (e.g. electrically coupled) via at least one electrical connector 210. Accordingly, the interconnect structure 208, which may be coupled (e.g. electrically coupled) to the first semiconductor chip 202 and/or the second semiconductor chip 204, may be coupled (e.g. additionally coupled) to the at least one electrical connector 210.

The chip arrangement 200 may include at least one electrical connector 212 disposed at the second side 206b of the encapsulation layer 206. The at least one electrical connector 212 may include, or may consist of, at least one electrically conductive material selected from a group of electrically conductive materials, the group consisting of: a metal or metal alloy. For example, the at least one electrical connector 212 may consist of a solder material (e.g. an alloy of tin, silver, and copper). By way of another example, the at least one electrical connector 212 may consist of copper, palladium, titanium, tungsten, nickel, gold, aluminum or a conductive paste or a stack or an alloy including or consisting of at least one of the listed metals.

The at least one electrical connector 212 may be coupled (e.g. electrically coupled) to the interconnect structure 208. For example, as described above, the interconnect structure 208 may include a part 208c, 208d (e.g. RDL, for example, a frontside RDL) extending over the second side 204b of the second semiconductor chip 204. The at least one electrical connector 212 disposed at the second side 206b of the encapsulation layer 206 may be coupled (e.g. electrically coupled) to the part 208c, 208d (e.g. RDL, for example, frontside RDL) of the interconnect structure 208 extending over the second side 204b of the second semiconductor chip 204.

The at least one electrical connector 212 may include, or may be, at least one of a ball, a bump and a pillar. The at least one electrical connector 212 may, for example, provide an interface (e.g. a ball grid array of solder balls) for the chip arrangement 200. In other words, signals (e.g. electrical signals, power supply potentials, ground potentials, etc.) may be exchanged with the first semiconductor chip 202 and/or the second semiconductor chip 204 of the chip arrangement 200 via the at least one electrical connector 212.

The chip arrangement 200 may include an insulating layer 214 formed at the second side 206b of the encapsulating layer 206 and the second side 204b of the second semiconductor chip 204. The insulating layer 214 may, for example, insulate (e.g. electrically insulate) the interconnect structure 208 (e.g. the part 208c, 208d) of the chip arrangement 200. The part 208c, 208d (e.g. RDL, for example frontside RDL) of the at least one electrical connector 212 may, for example, be partially or fully disposed within the indulating layer 214.

The chip arrangement 200 may, for example, be used to package two or more chips (e.g. the first semiconductor chip 202 and the second semiconductor chip 204) that may, for example, be coupled (e.g. electrically coupled) to each other. For example, the chip arrangement 200 may be used to package a stack of two or more chips (e.g. the first semiconductor chip 202 and the second semiconductor chip 204) that may be integrated (e.g. vertically integrated) with each other. In other words, the chip arrangement 200 may, for example, be configured as a chip package. The chip arrangement 200 may, for example, be configured as an embedded wafer level ball grid array (eWLB) package. The chip arrangement 200 may, for example, be configured as a system-in-package (SiP). In other words, the chip arrangement 200 may be an SiP including a plurality of chips (or dies) (e.g. the first semiconductor chip 202 and the second semiconductor chip 204) enclosed in a single module that may, for example, perform functions of an electronic system. As compared to the conventional chip arrangements shown in FIG. 1A and FIG. 1B, the chip arrangement 200 may include, or may be, a fan-out wafer level package.

An effect provided by the chip arrangement 200 may be that the second semiconductor chip 204 (e.g. daughter die) does not limit the number of electrical connectors 212 that may be provided for an electrical connection to or from the first semiconductor chip 202 (e.g. mother die).

An effect provided by the chip arrangement 200 may be that an area available for electrical routing on the first semiconductor chip 202 (e.g. mother die) is not limited by a presence of the second semiconductor chip 204 (e.g. daughter die).

An effect provided by the chip arrangement 200 may be that the at least one electrical connector 212 may be formed at a side (e.g. a backside) of the second semiconductor chip 204 (e.g. daughter die). This may be desirable, for example, when the second semiconductor chip 204 (e.g. daughter die) is not very small.

An effect provided by the chip arrangement 200 may be that electrical routing may be formed at a side (e.g. a backside) of the second semiconductor chip 204 (e.g. daughter die). This may be desirable, for example, when the second semiconductor chip 204 (e.g. daughter die) is not very small.

An effect provided by the chip arrangement 200 may be that the second semiconductor chip 204 (e.g. daughter die) may be thinned to a desired thickness after attaching it to the first semiconductor chip 202 (e.g. mother die).

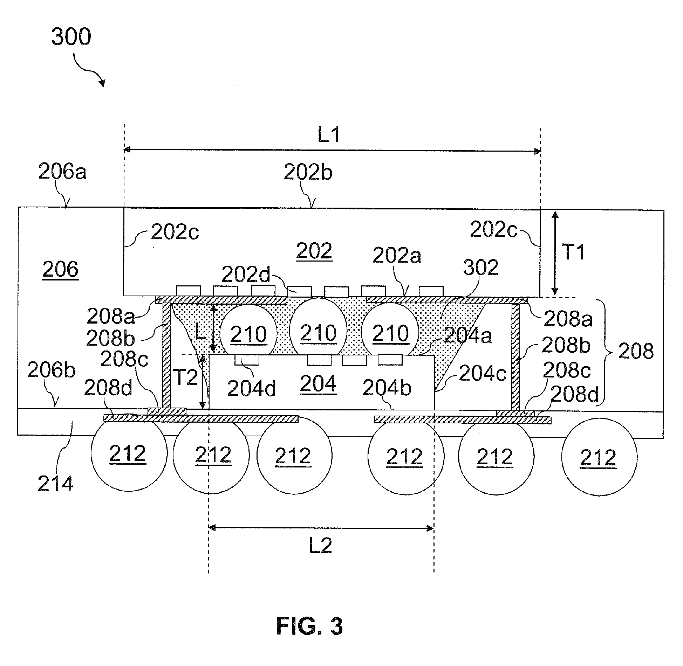

FIG. 3 shows a cross-sectional view of a chip arrangement 300 including a filling material 302 disposed between the first semiconductor chip 202 and the second semiconductor chip 204.

Reference signs in FIG. 3 that are the same as in FIG. 2 denote the same or similar elements as in FIG. 2. Thus, those elements will not be described in detail again here; reference is made to the description above. The various effects described above in relation to the chip arrangement 200 shown in FIG. 2 may be analogously valid for the chip arrangement 300 shown in FIG. 3. Differences between FIG. 3 and FIG. 2 are described below.

The chip arrangement 300 may include a filling material 302 disposed between the first side 202a of the first semiconductor chip 202 and the first side 204a of the second semiconductor chip 204. As shown in FIG. 3, the chip arrangement 300 may include at least one electrical connector 210 that may be disposed between the first side 202a of the first semiconductor chip 202 and the first side 204a of the second semiconductor chip 204. The filling material 302 may, for example, partially enclose the at least one electrical connector 210 (e.g. bump and/or pillar). The filling material 302 may, for example, be formed by means of an underfilling process. For example, the underfilling process may include pre-applying the filling material 302 to the first semiconductor chip 202 and/or the second semiconductor chip 204. For example, the underfilling process may include a capillary underfilling process where the filling material 302 may be formed between the first side 202a of the first semiconductor chip 202 and the first side 204a of the second semiconductor chip 204 by means of capillary action.

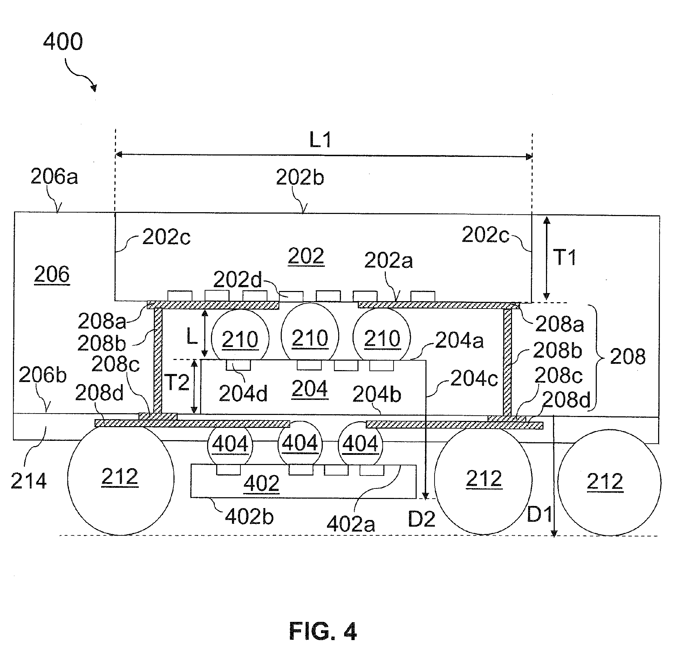

FIG. 4 shows a cross-sectional view of a chip arrangement 400 including a third semiconductor chip 402.

Reference signs in FIG. 4 that are the same as in FIG. 2 denote the same or similar elements as in FIG. 2. Thus, those elements will not be described in detail again here; reference is made to the description above. The various effects described above in relation to the chip arrangement 200 shown in FIG. 2 may be analogously valid for the chip arrangement 400 shown in FIG. 4. Differences between FIG. 4 and FIG. 2 are described below.

The chip arrangement 400 may include a third semiconductor chip 402. The third semiconductor chip 402 may, for example, be a daughter die that may, for example, be coupled (e.g. electrically coupled) to the first semiconductor chip 202 (e.g mother die) and/or the second semiconductor chip 204 (e.g. daughter die).

The third semiconductor chip 402 may include a first side 402a and a second side 402b opposite the first side 402a. The first side 402a and the second side 402b of the third semiconductor chip 402 may include, or may be, a frontside and a backside of the third semiconductor chip 402, respectively. By way of another example, the first side 402a of the third semiconductor chip 402 may include, or may be, an active side of the third semiconductor chip 402. By way of yet another example, the first side 402a and the second side 402b of the third semiconductor chip 402 may include, or may be, a bottom surface and a top surface of the third semiconductor chip 402, respectively.

The third semiconductor chip 402 may, for example, be disposed at at least one of the second side 204b of the second semiconductor chip 204 and the second side 206b of the encapsulation layer 206. For example, the third semiconductor chip 402 shown in FIG. 4 may be disposed at a part of the second side 204b of the second semiconductor chip 204 and at a part of the second side 206b of the encapsulation layer 206.

The second side 402b of the third semiconductor chip 402 may face in the same direction as the second side 204b of the second semiconductor chip 204 and the second side 206b of the encapsulation layer 206. In other words, the first side 402a of the third semiconductor chip 402 may face the second side 204b of the second semiconductor chip 204 and/or the second side 206b of the encapsulation layer 206.

The third semiconductor chip 402 may be coupled (e.g. electrically coupled) to the interconnect structure 208 via, for example, at least one electrical connector (e.g. interconnect, e.g. chip interconnect) 404 disposed between the first side 402a of the third semiconductor chip 402 and the interconnect structure 208. For example, in the chip arrangement 400 shown in FIG. 4, the third semiconductor chip 402 may be coupled (e.g. electrically coupled) to the part 208c, 208d (e.g. RDL, for example frontside RDL) of the interconnect structure 208 that may extend over the second side 204b of the second semiconductor chip 204 via at least one electrical connector (e.g. interconnect, e.g. chip interconnect) 404.

The at least one electrical connector 404 may be configured in a similar manner as the at least one electrical connector 210. The at least one electrical connector 404 may include, or may be, at least one of a ball, a bump and a pillar. The at least one electrical connector 404 may include, or may consist of, at least one electrically conductive material selected from a group of electrically conductive materials, the group consisting of: a metal or metal alloy. For example, the at least one electrical connector 404 may consist of a solder material (e.g. an alloy of tin, silver, and copper). By way of another example, the at least one electrical connector 404 may consist of copper, palladium, titanium, tungsten, nickel, gold, aluminum or a conductive paste or a stack or an alloy including or consisting of one or more of the listed metals.

The third semiconductor chip 204 may be disposed at at least one of the second side 204b of the second semiconductor chip 204 and the second side 206b of the encapsulation layer 206 such that the at least one electrical connector 212 is disposed laterally adjacent to the third semiconductor chip 402, as shown in FIG. 4. The at least one electrical connector 212 may extend a distance D1 from the second side 206b of the encapsulation layer 206, and the second side 402b of the third semiconductor chip 402 may extend a distance D2 from the second side 206b of the encapsulation layer 206. The distance D2 may be less than the distance D1. In other words, the at least one electrical connector 212 may protrude farther from the second side 206b of the encapsulation layer 206 than the distance D2 between the second side 402b of the third semiconductor chip 402 and the second side 206b of the encapsulation layer 206.

An effect provided by the chip arrangement 400 may be that an additional semiconductor chip (e.g. the third semiconductor chip 402, e.g. an additional daughter die) may be included in the chip arrangement 400.

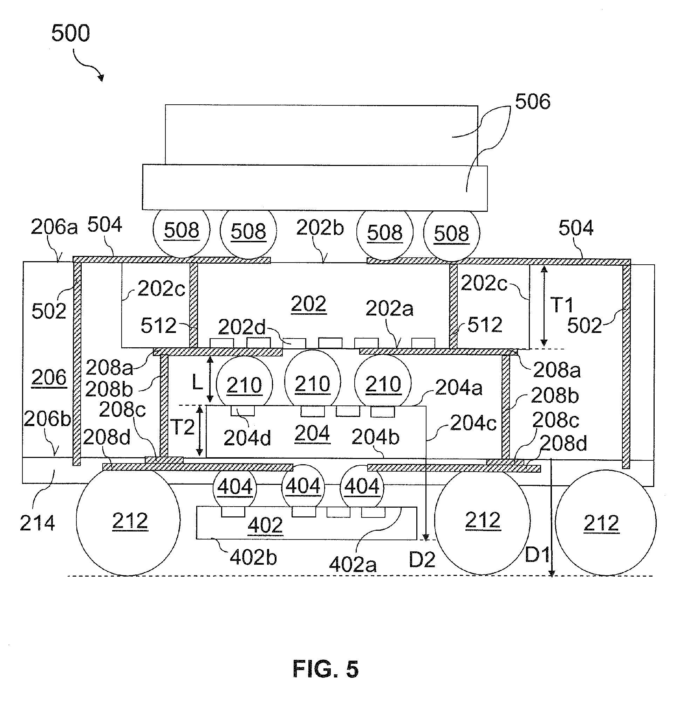

FIG. 5 shows a cross-sectional view of a chip arrangement 500 including at least one through-via 502 and a metallization layer 504.

Reference signs in FIG. 5 that are the same as in FIG. 4 denote the same or similar elements as in FIG. 4. Thus, those elements will not be described in detail again here; reference is made to the description above. The various effects described above in relation to the chip arrangement 400 shown in FIG. 4 may be analogously valid for the chip arrangement 500 shown in FIG. 5. Differences between FIG. 5 and FIG. 4 are described below.

The chip arrangement 500 may include at least one through-via 502 extending through the encapsulation layer 206 and/or at least one through-via 512 extending through the first semiconductor chip 202. The at least one through-via 502 may, for example, extend from the second side 206b of the encapsulation layer 206 to the first side 206a of the encapsulation layer 206. The at least one through-via 512 may, for example, extend from the first side 202a of the first semiconductor chip 202 to the second side 202b of the first semiconductor chip 202. The at least one through-via 502 may, for example, be a through-mold via (TMV) (e.g. when the encapsulation layer 206 includes, or consists of, a molding material). The at least one through-via 512 may, for example, be a through-silicon via (TSV) (e.g. when the first semiconductor chip 202 includes silicon). The at least one through-via 502 and/or the at least one through-via 512 may, for example, include, or may consist of, at least one electrically conductive material, e.g. a metal and/or metal alloy. The at least one electrically conductive material may be selected from a group of electrically conductive materials, the group consisting of: aluminum, copper, and gold, although other electrically conductive materials may be possible as well.

The chip arrangement 500 may include a metallization layer 504. The metallization layer 504 may, for example, include, or may consist of an electrically conductive material, e.g. a metal and/or metal alloy. The electrically conductive material may be selected from a group of electrically conductive materials, the group consisting of: aluminum, tungsten, titanium, copper, nickel, palladium and gold or a conductive paste (e.g. a polymer filled with electrically conductive particles), although other electrically conductive materials may be possible as well.

The metallization layer 504 may be disposed at least partially over the first side 206a of the encapsulation layer 206 and may be coupled (e.g. electrically coupled) to the at least one through-via 502. For example, the metallization layer 504 shown in FIG. 5 may be disposed over a part of the first side 206a of the encapsulation layer 206. By way of another example, the metallization layer 504 may be formed over a part of the first side 206a of the encapsulation layer 206 and over a part of of the second side 202b of the first semiconductor chip 202, as shown in FIG. 5.

The metallization layer 504 may, for example, be for coupling (e.g. electrically coupling) at least one additional chip package. In this regard, the chip arrangement 500 may further include at least one additional chip package 506, which may be disposed over at least one of the first side 206a of the encapsulation layer 206 and the second side 202b of the first semiconductor chip 202. In other words, the chip arrangement 500 may include, or may be, a package stack (namely, a stack of two or more chip packages).

The at least one additional chip package 506 may be coupled (e.g. electrically coupled) to the metallization layer 504. For example, the at least one additional chip package 506 may be coupled (e.g. electrically coupled) to the metallization layer 504 via at least one electrical connector (e.g. interconnect, e.g. chip interconnect) 508 that may disposed between the at least one additional chip package 506 and at least one of the first side 206a of the encapsulation layer 206 and the second side 202b of the first semiconductor chip 202. The at least one additional chip package 506 may be coupled (e.g. electrically coupled) to at least one of the first semiconductor chip 202 (e.g. to the first side 202a of the first semiconductor chip 202), the second semiconductor chip 204, and the third semiconductor chip 402 by means of the at least one through-via 502 (e.g. at least one TMV) and/or the at least one through-via 512 (e.g. at least one TSV).

The at least one electrical connector 508 may be configured in a similar manner as the at least one electrical connector 212. The at least one electrical connector (e.g. interconnect, e.g. chip interconnect) 508 may include, or may consist of, at least one electrically conductive material selected from a group of electrically conductive materials, the group consisting of: a metal or metal alloy. For example, the at least one electrical connector 508 may consist of a solder material (e.g. an alloy of tin, silver, and copper). By way of another example, the at least one electrical connector 508 may consist of copper, palladium, titanium, tungsten, nickel, gold, aluminum or a conductive paste or a stack or an alloy including or consisting of one or more of the listed metals.

The at least one electrical connector 508 may include, or may be, at least one of a ball, a bump and a pillar. The at least one electrical connector 508 may, for example, be an interface (e.g. a ball grid array of solder balls) for the at least one additional chip package 506.

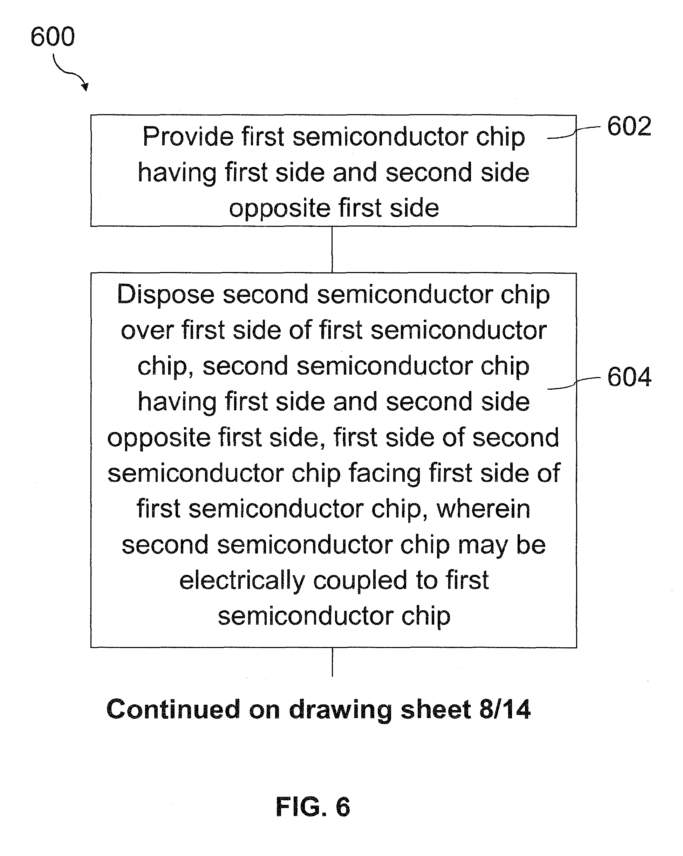

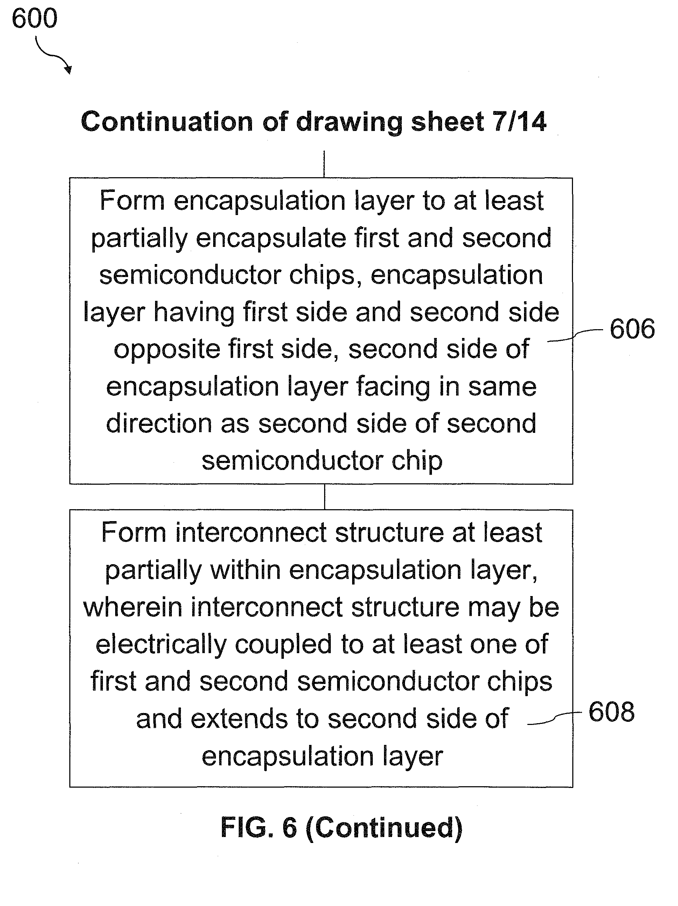

FIG. 6 shows a method 600 for manufacturing a chip arrangement.

The method 600 may, for example, be used to manufacture at least one of the chip arrangements shown in FIG. 2 to FIG. 5.

The method 600 may include: providing a first semiconductor chip having a first side and a second side opposite the first side (in 602); disposing a second semiconductor chip over the first side of the first semiconductor chip, the second semiconductor chip having a first side and a second side opposite the first side, the first side of the second semiconductor chip facing the first side of the first semiconductor chip, wherein the second semiconductor chip may be electrically coupled to the first semiconductor chip (in 604); forming an encapsulation layer to at least partially encapsulate the first and second semiconductor chips, the encapsulation layer having a first side and a second side opposite the first side, the second side of the encapsulation layer facing in a same direction as the second side of the second semiconductor chip (in 606); and forming an interconnect structure at least partially within the encapsulation layer, wherein the interconnect structure may be electrically coupled to at least one of the first and second semiconductor chips and extends to the second side of the encapsulation layer (in 608).

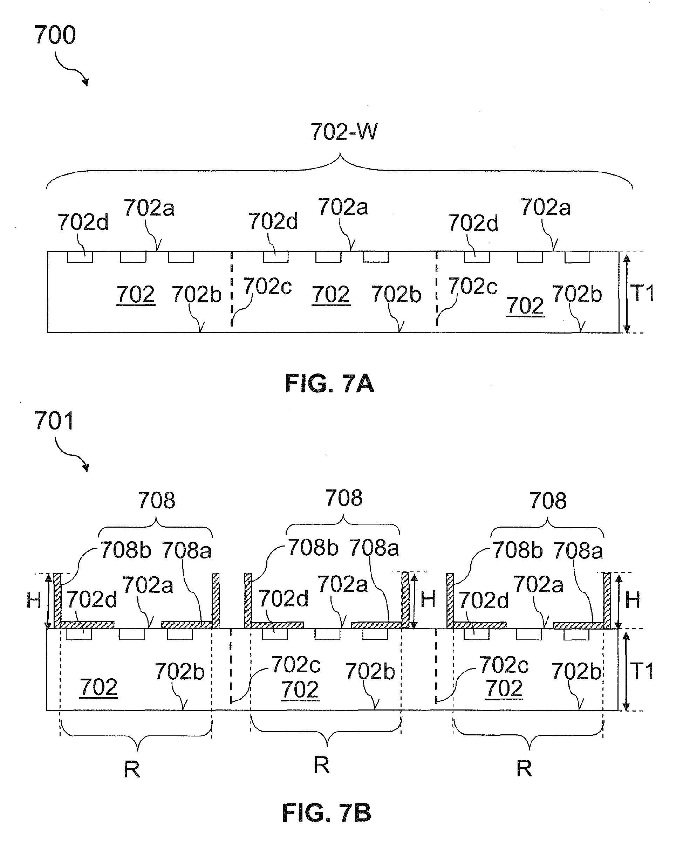

FIG. 7A to FIG. 7I show a process flow for a method for manufacturing a chip arrangement.

The method shown in FIG. 7A to FIG. 7I may, for example, be used to manufacture at least one of the chip arrangements shown in FIG. 2 to FIG. 5.

The method shown in FIG. 7A to FIG. 7I may, for example, be used to couple (e.g. electrically couple) a daughter die to a mother die prior to packaging the mother die.

The method shown in FIG. 7A to FIG. 7I may allow a daughter die to be grinded to a desired thickness after attaching it to a mother die, after a reflow process that may couple (e.g. electrically couple) the daughter die to the mother die, and after an embedding process that may encapsulate the mother die and the daughter die.

As shown in FIG. 7A in a view 700, the method for manufacturing a chip arrangement may include providing a first semiconductor chip 702 having a first side 702a and a second side 702b opposite the first side 702a.

The first semiconductor chip 702 may further include at least one sidewall 702c. The first side 702a and the second side 702b of the first semiconductor chip 702 may include, or may be, a frontside and a backside of the first semiconductor chip 702, respectively. By way of another example, the first side 702a of the first semiconductor chip 702 may include, or may be, an active side of the first semiconductor chip 702. The first semiconductor chip 702 may, for example, be a mother die (which may also be referred to as a carrier die).

As shown in FIG. 7A, providing the first semiconductor chip 702 may include providing a wafer 702-W, which may include a plurality of first semiconductor chips 702. The wafer 702-W may, for example, have a thickness T1. The thickness T1 may be a desired thickness of each of the plurality of first semiconductor chips 702. As described above, the first semiconductor chip 702 may, for example, be a mother die (which may also be referred to as a carrier die). Accordingly, the wafer 702-W may, for example, be a mother wafer (which may also be referred to as a carrier wafer).

Each of the plurality of first semiconductor chips 702 may include at least one respective electrically conductive contact 702d formed at a respective first side 702a of the respective first semiconductor chip 702. The at least one respective electrically conductive contact 702d formed at a respective first side 702a of the respective first semiconductor chip 702 may include, or may be, a pad (e.g. a contact pad and/or a bonding pad). The at least one respective electrically conductive contact 702d may, for example, provide an interface (e.g. an electrical interface) for the respective first semiconductor chip 702. In other words, signals (e.g. electrical signals, power supply potentials, ground potentials, etc.) may be exchanged with the respective first semiconductor chip 702 via the at least one respective electrically conductive contact 702d.

As shown in FIG. 7B in a view 701, the method for manufacturing a chip arrangement may include forming an interconnect structure 708.

The interconnect structure 708 may include, or may consist of, at least one electrically conductive material selected from a group of electrically conductive materials, the group consisting of: a metal or a metal alloy, although other electrically conductive materials may be possible as well. For example, the interconnect structure 708 may include, or may consist of, copper, palladium, titanium, tungsten, nickel, gold, aluminum or a conductive paste or a stack or an alloy including or consisting of one or more of the listed metals.

The interconnect structure 708 may be formed by, for example, at least one of the following processes: sputtering, resist plating, electroplating, stripping, etching, electro-less plating, dispensing, and printing, although other processes may be possible as well.

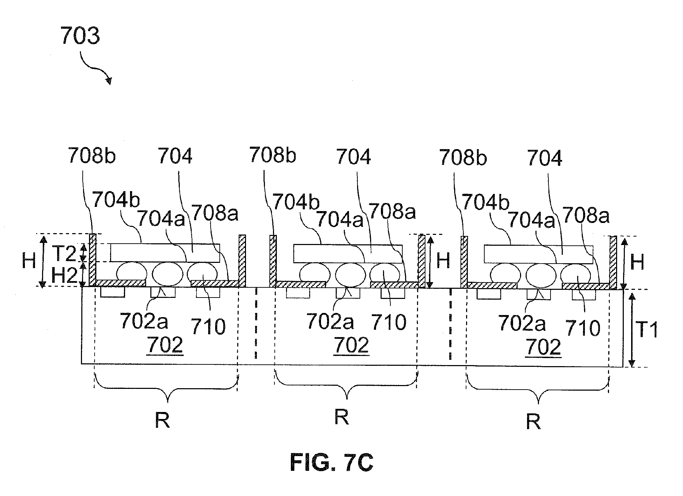

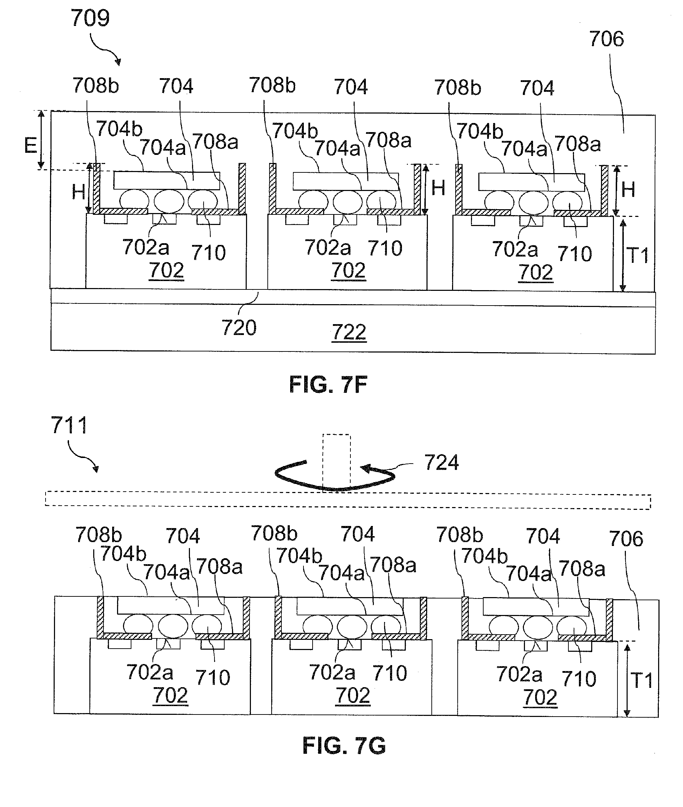

The interconnect structure 708 may, for example, include a part 708b formed over the first side 702a of the first semiconductor chip 702. The part 708b may, for example, include, or may be at least one pillar (e.g. metal pillar). Accordingly, forming the interconnect structure 708 may include forming at least one pillar (e.g. metal pillar) over the first side 702a of the first semiconductor chip 702. The part 708b (e.g. at least one pillar) may be formed outside a receiving region R that may be configured to receive a daughter die. A height H of the part 708b (e.g. at least one pillar, e.g. metal pillar) may be greater than or equal to a thickness of the daughter die that may be received in the region R, and a height of at least one electrical connector that may be disposed between the daughter die and the first side 702a of the first semiconductor chip 702 (see description below for FIG. 7C). The height H of the part 708c (e.g. at least one pillar, e.g. metal pillar) may, for example, be required to be sufficiently high in order for it (namely, the part 708c) to be accessible after a grinding process (see description below in respect of FIG. 7G).

The part 708b (e.g. at least one pillar, for example metal pillar) of the interconnect structure 708 may be coupled (e.g. electrically coupled) to the at least one electrically conductive contact 702d of the first semiconductor chip 702, for example, via a part 708a of the interconnect structure 708. The part 708a of the interconnect structure 708 may include, or may be, a redistribution layer (RDL) disposed at the first side 702a of the first semiconductor chip 702. The part 708a (e.g. RDL) of the interconnect structure 708 may be configured to redistribute and/or re-map electrical connections from the first side 702a of the first semiconductor chip 702. Accordingly, forming the interconnect structure 708 may include forming the part 708a (e.g. RDL) over the first side 702a of the first semiconductor chip 702, wherein the part 708a (e.g. RDL) may couple (e.g. electrically couple) the part 708b (e.g. at least one pillar, for example metal pillar) to the at least one electrically conductive contact 702d of the first semiconductor chip 702.

As shown in FIG. 7C in a view 703, the method for manufacturing a chip arrangement may include disposing a second semiconductor chip 704 over the first side 702a of the first semiconductor chip 702.

The second semiconductor chip 704 may, for example, be a daughter die. The second semiconductor chip 704 may include a first side 704a and a second side 704b opposite the first side 704a. The first side 704a and the second side 704b of the second semiconductor chip 704 may include, or may be, a frontside and a backside of the second semiconductor chip 704, respectively. By way of another example, the first side 704a of the second semiconductor chip 704 may include, or may be, an active side of the second semiconductor chip 704.

The second semiconductor chip 704 may be disposed at the receiving region R, and over the first side 702a of the first semiconductor chip 702. The second semiconductor chip 704 may be disposed over the first side 702a of the first semiconductor chip 702 such that the first side 704a of the second semiconductor chip 704 may face the first side 702a of the first semiconductor chip 702.

The second semiconductor chip 704 may, for example, be coupled (e.g. electrically coupled) to the first semiconductor chip 702 (e.g. mother die or carrier die). Accordingly, disposing the second semiconductor chip 704 over the first side 702a of the first semiconductor chip 702 may include attaching the first side 704a of the second semiconductor chip 704 to the first side 702a of the first semiconductor chip 702, for example, via at least one electrical connector 710. The at least one electrical connector 710 may be formed by means of at least one of a mass reflow bonding process, a thermo-compression bonding process, and gluing.

As described above in relation to FIG. 7B, the height H of the part 708b (e.g. at least one pillar) may be greater than or equal to a thickness T2 of the second semiconductor chip 702 that may be received in the region R, and a height H2 of the at least one electrical connector 710 that may be disposed between the second semiconductor chip 702 and the first side 702a of the first semiconductor chip 702

The at least one electrical connector 710 may include, or may consist of, at least one electrically conductive material selected from a group of electrically conductive materials, the group consisting of: a metal or metal alloy. For example, the at least one electrical connector 710 may consist of a solder material (e.g. may contain tin, silver, nickel, conductive paste or copper or an alloy of one or more of the listed materials). By way of another example, the at least one electrical connector 710 may consist of copper, palladium, titanium, tungsten, nickel, gold, aluminum or a conductive paste or a stack or an alloy including or consisting of at least one of the listed metals.

The at least one electrical connector 710 may include, or may be, at least one of a ball, a bump and a pillar, although other electrical connectors may be possible as well. By way of an example, the at least one electrical connector 710 may include, or may be, a bump, for example, a solder bump and/or a micro-bump (e.g. micro solder bump) and/or a flip-chip bump. By way of another example, the at least one electrical connector 710 may include, or may be, a pillar bump (e.g. a metal-pillar bump, for example a copper-pillar bump).

The method for manufacturing a chip arrangement may include forming a filling layer disposed between the first side 702a of the first semiconductor chip 702 and the first side 704a of the second semiconductor chip 704 (not shown in FIG. 7C). The filling layer may include, or may consist of, a filling material which may, for example, partially enclose the at least one electrical connector 710 (e.g. bump and/or pillar). The filling layer may, for example, be formed by means of an underfilling process. For example, the underfilling process may include pre-applying filling material to the first semiconductor chip 702 and/or the second semiconductor chip 704. For example, the underfilling process may include a capillary underfilling process where the filling layer may be formed between the first side 702a of the first semiconductor chip 702 and the first side 704a of the second semiconductor chip 704 by means of capillary action.

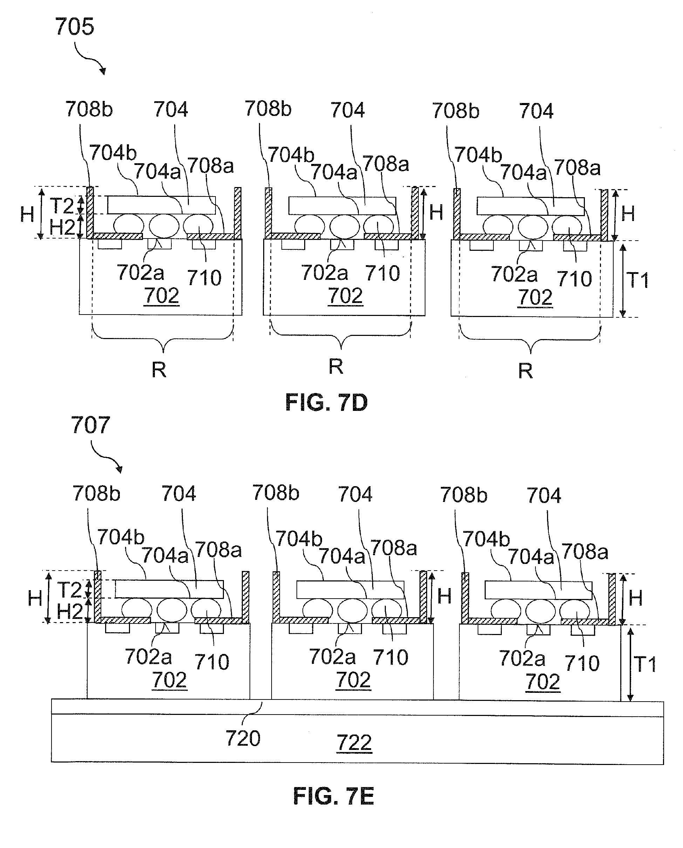

As shown in FIG. 7D in a view 705, the method for manufacturing a chip arrangement may include separating the plurality of first semiconductor chips 702. For example, the wafer 702-W (e.g. mother wafer) may be diced (e.g. by means of laser dicing and/or sawing) to separate the plurality of first semiconductor chips 702. Hereafter, the diced stacks, which may include the first semiconductor chip 702 and the second semiconductor chip 704 may be reconstituted in a similar or the same manner as in a standard eWLB process, as described in the following.

The method for manufacturing a chip arrangement may include forming an encapsulation layer 706 to at least partially encapsulate the first and second semiconductor chips 702, 704. This is shown in FIG. 7E to FIG. 7G.

As shown in FIG. 7E in a view 707, forming the encapsulation layer 706 to at least partially encapsulate the first and second semiconductor chips 702, 704 may include placing the first semiconductor chip 702 and the second semiconductor chip 704 on an adhesive tape 720 (e.g. a removable double-sided adhesive tape), which may be disposed on a carrier 722. The second surface 702b of the first semiconductor chip 702 may, for example, be in contact with the adhesive tape 720. In other words, the part 708b of the interconnect structure 708 and the second surface 704b of the second semiconductor chip 704 may face away from the carrier 722, as shown in FIG. 7E. In another example, however, the part 708b of the interconnect structure 708 and the second surface 704b of the second semiconductor chip 704 may face the carrier 722.

As shown in FIG. 7F in a view 709, forming the encapsulation layer 706 to at least partially encapsulate the first and second semiconductor chips 702, 704 may include embedding the first semiconductor chip 702 and the second semiconductor chip 704 in an encapsulation layer 706. For example, the encapsulation layer 706 may cover the second side 704b of the second semiconductor chip 704 and the part 708b (e.g. at least one metal pillar) of the interconnect structure 708.

The encapsulation layer 706 may be formed by means of at least one of a molding process (e.g. compression mold flow process), a lamination process, and a pressing process. In other words, the first and second semiconductor chips 702, 704 may be at least partially embedded in the encapsulation layer 706 by means of molding (e.g. compression mold flow) and/or laminating.

The encapsulation layer 706 may have a first side 706a and a second side 706b opposite the first side 706a. The second side 706b of the encapsulation layer 706 may, for example, face in a same direction as the second side 704b of the second semiconductor chip 704. The first side 706a of the encapsulation layer 706 may, for example, be a backside of a chip arrangement manufactured according to the method shown in FIG. 7A to FIG. 7I. The second side 706b of the encapsulation layer 706 may, for example, be a frontside of a chip arrangement manufactured according to the method shown in FIG. 7A to FIG. 7I.

The adhesive tape 720 may be subsequently cured, and the carrier 722 and the adhesive tape 720 may, for example, be released from the first semiconductor chip 702 and the encapsulation layer 706.

A thickness E of the encapsulation layer 706 formed over the second surface 704b of the second semiconductor chip 704 may, for example, depend on a filler size of the encapsulation layer 706 (e.g. including or consisting of a mold compound), and may, for example, be in the range from about 50 µm to about 150 µm, for example in the range from about 70 µm to about 140 µm, for example in the range from about 90 µm to about 130 µm, for example about 120 µm, although other thicknesses may be possible as well. For example, the thickness E may be about 1.5 to 2 times the filler size of the encapsulation layer 706 (e.g. including or consisting of a mold compound). For example, in case the filler size (e.g. maximum filler size) of the encapsulation layer 706 (e.g. including or consisting of a mold compound) is about 70 µm, the thickness E of the encapsulation layer 706 formed over the second surface 704b of the second semiconductor chip 704 may be in the range from about 100 µm to about 140 µm, for example about 120 µm. The encapsulation layer 706 (e.g. mold compound) may be at least flush with the second surface 704b (e.g. backside) of the second semiconductor chip 704. Accordingly, a part of the encapsulation layer 706 formed over the second surface 704b of the second semiconductor chip 704 may be removed.

As shown in FIG. 7G in a view 711, forming the encapsulation layer 706 to at least partially encapsulate the first and second semiconductor chips 702, 704 may include removing a part of the encapsulation layer 706 to expose the part 708b (e.g. at least one metal pillar) of the interconnect structure 708.

Removing a part of the encapsulation layer 706 to expose the part 708b (e.g. at least one metal pillar) of the interconnect structure 708 may be performed by means of, for example, a grinding process (indicated in FIG. 7G as arrow 724).

The grinding process may, for example, be additionally used to thin the second semiconductor chip 704 after forming the encapsulation layer 706. In other words, the second semiconductor chip 704 that may be embedded in the encapsulation layer 706 may be thinned together with the encapsulation layer 706 by means of the grinding process. For example, the grinding process may additionally grind the second surface 704b of the second semiconductor chip 704. The semiconductor chip 704 may be thinned to any desired thickness, for example a thickness of less than or equal to about 100 µm, for example less than or equal to about 75 µm, for example less than or equal to about 50 µm, for example less than or equal to about 20 µm, for example less than or equal to about 15 µm, although other thicknesses may be possible as well.

Accordingly, as shown in FIG. 7G, the second semiconductor chip 704 (e.g. daughter die) may be grinded to a desired thickness after attaching it to the first semiconductor chip 702 (e.g. mother die), after a reflow process that may couple (e.g. electrically couple) the second semiconductor chip 704 (e.g. daughter die) die to the first semiconductor chip 702 (e.g. mother die) (e.g. via the at least one electrical connector 710), and after an embedding process that may encapsulate the first semiconductor chip 702 (e.g. mother die) and the second semiconductor chip 704 (e.g. daughter die).

The grinding process 724 may, for example, leave a residue on the second side 704b of the second semiconductor chip 704 (e.g. daughter die). The residue may, for example, include material of the second semiconductor chip 704 (e.g. daughter die) and/or material of the encapsulation layer 706 and/or material (e.g. copper) of the part 708c (e.g. at least one pillar, e.g. metal pillar) of the interconnect structure 708. This residue may be removed by means of an etching process (e.g. dry and/or wet etch process) and/or a cleaning process (e.g. a dissolution process).

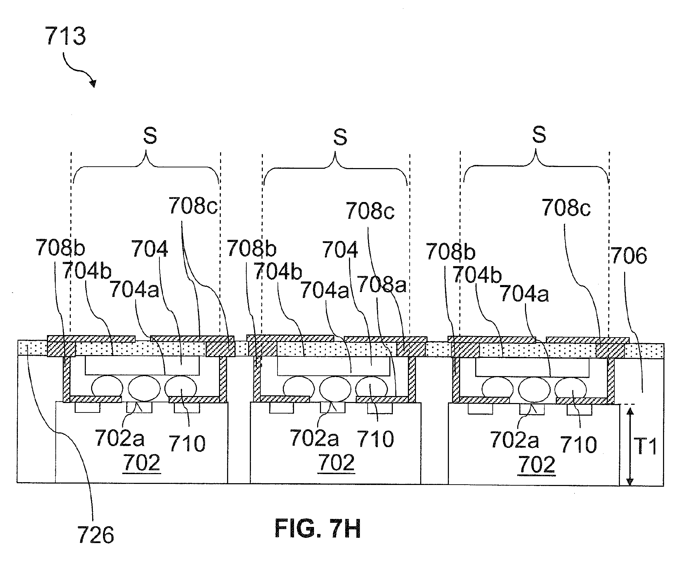

As shown in FIG. 7H in a view 713, the method for manufacturing a chip arrangement may include forming a redistribution layer (RDL) 708c over at least one of the second side 706b of the encapsulation layer 706 and the second side 704b of the second semiconductor chip 704. The RDL 708c may form a part of the interconnect structure 708. The RDL 708c may, for example, be formed by means of thin-film technology (e.g. a sputtering process and/or a plating process) and/or PCB (printed circuit board) technology (e.g. electroless plating process and/or electroplating process), or by means of other methods (e.g. printing, seeding and structuring (e.g. by laser) for electroless plating). The method for manufacturing a chip arrangement may include forming a dielectric layer 726, for example, prior to forming the RDL 708c. The dielectric layer 726 may, for example, be strucutured by means of etching (e.g. laser etching) and/or lithography (e.g. photolithography).

As shown in FIG. 7H, there may be a region S at the second surface 706b of the encapsulation layer 706 that may be used for electrical routing (e.g. by means of the RDL 708c). Accordingly, an area available for electrical routing on the first semiconductor chip 702 (e.g. mother die) may not be limited by a presence of the second semiconductor chip 704 (e.g. daughter die). Furthermore, electrical routing (e.g. by means of the RDL 708c) may be formed at a side 704b (e.g. a backside) of the second semiconductor chip 704 (e.g. daughter die). This may be desirable, for example, when the second semiconductor chip 704 (e.g. daughter die) is not very small (e.g. has a wide lateral extent).

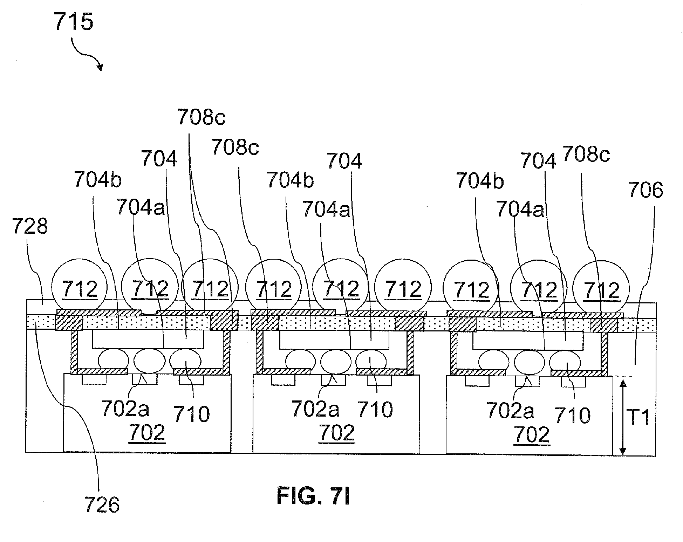

As shown in FIG. 7I in a view 715, the method for manufacturing a chip arrangement may include forming at least one electrical connector 712 (e.g. solder ball) over at least one of the second side 706b of the encapsulation layer 706 and the second side 704b of the second semiconductor chip 704. The at least one electrical connector 712 (e.g. solder ball) may be formed, for example, after forming a stop layer 728 (e.g. a solder stop layer) over the dielectric layer 726. The at least one electrical connector 712 may be coupled (e.g. electrically coupled) to the interconnect structure 708. For example, the at least one electrical connector 712 may be coupled (e.g. electrically coupled) to the RDL 708c of the interconnect structure 708.

As shown in FIG. 7I, the second semiconductor chip 704 (e.g. daughter die) may not limit the number of electrical connectors 712 that may be provided on the chip arrangement manufactured according to the method presented in FIG. 7A to FIG. 7I. Furthermore, the at least one electrical connector 712 may be formed at a side (e.g. a backside 704B) of the second semiconductor chip 704 (e.g. daughter die). This may be desirable, for example, when the second semiconductor chip 704 (e.g. daughter die) is not very small.

The chip arrangement manufactured according to the method presented in FIG. 7A to FIG. 7I may be thicker compared to the chip arrangement 100 (shown in FIG. 1A) and/or the chip arrangement 101 (shown in FIG. 1B). However, according to the method presented in FIG. 7A to FIG. 7I, the second semiconductor chip 704 (e.g. daughter die) may be thinned to smaller thicknesses (e.g. less than or equal to about 100 µm, for example less than or equal to about 75 µm, for example less than or equal to about 50 µm, for example less than or equal to about 20 µm, for example less than or equal to about 15 µm) compared to the chip arrangements 100 and 101. This may be a result of the second semiconductor chip 704 (e.g. daughter die) being embedded in the encapsulation layer 706 (e.g. mold compound) and being thinned together with the encapsulation layer 706 (e.g. mold compound), as shown in FIG. 7G. This may be in contrast to the chip arrangements 100 and 101 where the daughter die may have to be thinned prior to assembly to the mother die.

According to various examples described herein, a chip arrangement may be provided. The chip arrangement may include: a first semiconductor chip having a first side and a second side opposite the first side; a second semiconductor chip having a first side and a second side opposite the first side, the second semiconductor chip disposed at the first side of the first semiconductor chip and electrically coupled to the first semiconductor chip, the first side of the second semiconductor chip facing the first side of the first semiconductor chip; an encapsulation layer at least partially encapsulating the first semiconductor chip and the second semiconductor chip, the encapsulation layer having a first side and a second side opposite the first side, the second side facing in a same direction as the second side of the second semiconductor chip; and an interconnect structure disposed at least partially within the encapsulation layer and electrically coupled to at least one of the first and second semiconductor chips, wherein the interconnect structure extends to the second side of the encapsulation layer.

The chip arrangement may further include at least one electrical connector disposed between the first side of the first semiconductor chip and the first side of the second semiconductor chip, the at least one electrical connector electrically coupling the first semiconductor chip to the second semiconductor chip.

The first side of the first semiconductor chip may be a front side of the first semiconductor chip and the second side of the first semiconductor chip may be a back side of the first semiconductor chip.

The first side of the first semiconductor chip may be an active side of the first semiconductor chip.

The first side of the second semiconductor chip may be a front side of the second semiconductor chip and the second side of the second semiconductor chip may be a back side of the second semiconductor chip.

The first side of the second semiconductor chip may be an active side of the second semiconductor chip.

The interconnect structure may extend from the first side of the first semiconductor chip to the second side of the encapsulation layer.

The interconnect structure may extend from between the first side of the first semiconductor chip and the first side of the second semiconductor chip to the second side of the encapsulation layer.

The interconnect structure may further extend over the second side of the second semiconductor chip.

The second side of the encapsulation layer may be substantially flush with the second side of the second semiconductor chip.

The first side of the encapsulation layer may be substantially flush with the second side of the first semiconductor chip.

The chip arrangement may further include: at least one electrical connector disposed at the second side of the encapsulation layer and electrically coupled to the interconnect structure.

The at least one electrical connector disposed at the second side of the encapsulation layer may include a solder ball.

The interconnect structure may be electrically coupled to the first semiconductor chip and the second semiconductor chip.

The interconnect structure may be electrically coupled to the at least one electrical connector disposed between the first side of the first semiconductor chip and the first side of the second semiconductor chip.

The interconnect structure may include at least one metal pillar extending from the first side of the first semiconductor chip layer to the second side of the encapsulation layer.

The at least one metal pillar may be disposed laterally adjacent to the second semiconductor chip.

The interconnect structure may further include a redistribution layer disposed at the first side of the first semiconductor chip and electrically coupled to the at least one metal pillar.

The chip arrangement may further include: at least one electrical connector disposed at the second side of the second semiconductor chip and electrically coupled to the interconnect structure.

The at least one electrical connector disposed at the second side of the semiconductor chip may include, or may be, a solder ball.

The interconnect structure may further extend over the second side of the second semiconductor chip, and the chip arrangement may further include: at least one electrical connector disposed at the second side of the encapsulation layer and electrically coupled to the interconnect structure, and at least one electrical connector disposed at the second side of the second semiconductor chip and electrically coupled to the interconnect structure.

The at least one electrical connector disposed between the first side of the first semiconductor chip and the first side of the second semiconductor chip may include, or may be, at least one of the following: a bump; a metal pillar.

The encapsulation layer may include a material different from the first semiconductor chip and the second semiconductor chip.

The encapsulation layer may include an insulating material.

The encapsulation layer may include a plastic material.

The encapsulation layer may include a molding material.

The encapsulation layer may include a laminate material.

The first semiconductor chip may include at least one electrically conductive contact disposed at the first side of the first semiconductor chip and electrically coupled to the at least one electrical connector disposed between the first side of the first semiconductor chip and the first side of the second semiconductor chip.

The at least one electrically conductive contact of the first semiconductor chip may include a pad.

The second semiconductor chip may include at least one electrically conductive contact disposed at the first side of the second semiconductor chip and electrically coupled to the at least one electrical connector disposed between the first side of the first semiconductor chip and the first side of the second semiconductor chip.

The at least one electrically conductive contact of the second semiconductor chip may include a pad.

The first semiconductor chip may be larger than the second semiconductor chip.

The first semiconductor chip may have a larger chip area than the second semiconductor chip.

The first semiconductor chip may have a greater length than the second semiconductor chip.

The first semiconductor chip may extend laterally beyond the second semiconductor chip.

The second semiconductor chip may be disposed laterally within a boundary of the first semiconductor chip.

The second semiconductor chip may have a thickness of less than or equal to about 100 µm.

The second semiconductor chip may have a thickness of less than or equal to about 50 µm.

The chip arrangement may further include: a third semiconductor chip disposed at at least one of the second side of the second semiconductor chip and the second side of the encapsulation layer, the third semiconductor chip having a first side and a second side opposite the first side, the second side of the third semiconductor chip facing in the same direction as the second side of the second semiconductor chip and the second side of the encapsulation layer.

The first side of the third semiconductor chip may be a front side of the third semiconductor chip and the second side of the third semiconductor chip may be a back side of the third semiconductor chip.

The first side of the third semiconductor chip may be an active side of the third semiconductor chip.

The third semiconductor chip may be electrically coupled to the interconnect structure.

The chip arrangement may further include: at least one electrical connector disposed over the second side of the encapsulation layer laterally adjacent to the third semiconductor chip and electrically coupled to the interconnect structure, wherein the at least one electrical connector protrudes farther from the second side of the encapsulation layer than the third semiconductor chip.

The chip arrangement may further include: at least one electrical connector disposed over the second side of the encapsulation layer laterally adjacent to the third semiconductor chip and electrically coupled to the interconnect structure, wherein the at least one electrical connector protrudes farther from the second side of the encapsulation layer than a distance between the second side of the third semiconductor chip and the second side of the encapsulation layer.

The chip arrangement may further include a filling material disposed between the first side of the first semiconductor chip and the first side of the second semiconductor chip.

The chip arrangement may further include a filling material disposed between the first side of the first semiconductor chip and the first side of the second semiconductor chip and at least partially enclosing the at least one electrical connector.

The chip arrangement may be configured as a chip package.

The chip arrangement may be configured as an embedded wafer level ball grid array package.

The chip arrangement may further include: at least one through-via extending through the encapsulation layer, and a metallization layer disposed at least partially over the first side of the encapsulation layer and electrically coupled to the at least one through-via, for electrically coupling at least one additional chip package.

The at least one through-via may extend from the second side of the encapsulation layer to the first side of the encapsulation layer.

The chip arrangement may further include at least one additional chip package disposed over at least one of the first side of the encapsulation layer and the second side of the first semiconductor chip, and electrically coupled to the metallization layer.

According to various examples described herein, a method for manufacturing a chip arrangement may be provided. The method may include: providing a first semiconductor chip having a first side and a second side opposite the first side; disposing a second semiconductor chip over the first side of the first semiconductor chip, the second semiconductor chip having a first side and a second side opposite the first side, the first side of the second semiconductor chip facing the first side of the first semiconductor chip, wherein the second semiconductor chip is electrically coupled to the first semiconductor chip; forming an encapsulation layer to at least partially encapsulate the first and second semiconductor chips, the encapsulation layer having a first side and a second side opposite the first side, the second side of the encapsulation layer facing in a same direction as the second side of the second semiconductor chip; and forming an interconnect structure at least partially within the encapsulation layer, wherein the interconnect structure is electrically coupled to at least one of the first and second semiconductor chips and extends to the second side of the encapsulation layer.

Forming the encapsulation layer may include at least one of the following: a molding process; a lamination process.

Providing the first semiconductor chip may include providing a wafer including a plurality of first semiconductor chips, each of the plurality of first semiconductor chips having at least one electrically conductive contact at a respective first side of the respective first semiconductor chip.

The first semiconductor chip may have at least one electrically conductive contact at a first side of the first semiconductor chip, wherein forming the interconnect structure at least partially within the encapsulation layer may include: forming at least one metal pillar over the first side of the first semiconductor chip electrically coupled to the at least one electrically conductive contact of the first semiconductor chip, before disposing the second semiconductor chip over the first side of the first semiconductor chip; forming the encapsulation layer after disposing the second semiconductor chip over the first side of the first semiconductor chip to at least partially encapsulate the first and second semiconductor chips and the at least one metal pillar.

Disposing the second semiconductor chip over the first side of the first semiconductor chip may include attaching the first side of the second semiconductor to the first side of the first semiconductor chip.

Attaching the first side of the second semiconductor to the first side of the first semiconductor chip may include at least one of the following: mass reflow bonding; thermo-compression bonding; gluing.

Forming the interconnect structure at least partially within the encapsulation layer further may include: forming a redistribution layer over the first side of the first semiconductor chip electrically coupling the at least one metal pillar to the at least one electrically conductive contact of the first semiconductor chip, before disposing the second semiconductor chip over the first side of the first semiconductor chip.

The method may further include: thinning the second semiconductor chip after forming the encapsulation layer.

Thinning the second semiconductor chip may include grinding the second semiconductor chip and the encapsulation layer after forming the encapsulation layer.

Forming the encapsulation layer to at least partially encapsulate the first and second semiconductor chips and the at least one metal pillar may include: forming the encapsulation layer to cover the second side of the second semiconductor chip and the at least one metal pillar; removing a part of the encapsulation layer to expose the at least one metal pillar.

The method may further include: forming at least one electrical connector over at least one of the second side of the encapsulation layer and the second side of the second semiconductor chip after forming the encapsulation layer, wherein the at least one electrical connector is electrically coupled to the interconnect structure.

Forming the interconnect structure may further include: forming a redistribution layer over at least one of the second side of the encapsulation layer and the second side of the second semiconductor chip after forming the encapsulation layer to electrically couple the at least one electrical connector to the interconnect structure.

According to various examples described herein, an embedded wafer level ball grid array (eWLB) package may be provided. The eWLB package may include: a first semiconductor chip having a front side and a back side; a second semiconductor chip having a front side and a back side, the second semiconductor chip disposed at the front side of the first semiconductor chip, the front side of the second semiconductor chip facing the front side of the first semiconductor chip; at least one electrical connector disposed between the front side of the first semiconductor chip and the front side of the second semiconductor chip and electrically coupling the first semiconductor chip to the second semiconductor chip; an encapsulation layer at least partially encapsulating the first semiconductor chip, the second semiconductor chip and the at least one electrical connector, the encapsulation layer having a first side and a second side opposite the first side, the second side of the encapsulation layer facing in a same direction as the second side of the second semiconductor chip; an interconnect structure disposed at least partially within the encapsulation layer and electrically coupled to at least one of the first and second semiconductor chips, wherein the at least one interconnect structure extends from the first side of the first semiconductor chip to the second side of the encapsulation layer.

Various examples and aspects described in the context of one of the chip arrangements or chip packages or methods described herein may be analogously valid for the other chip arrangements or chip packages or methods described herein.

While various aspects have been particularly shown and described with reference to these aspects of this disclosure, it should be understood by those skilled in the art that various changes in form and detail may be made therein without departing from the spirit and scope of the disclosure as defined by the appended claims. The scope of the disclosure is thus indicated by the appended claims and all changes which come within the meaning and range of equivalency of the claims are therefore intended to be embraced.

## Claims

1. A chip arrangement, comprising:
a first semiconductor chip having a first side and a second side opposite the first side;
a second semiconductor chip having a first side and a second side opposite the first side, the second semiconductor chip disposed at the first side of the first semiconductor chip and electrically coupled to the first semiconductor chip, the first side of the second semiconductor chip facing the first side of the first semiconductor chip;
an encapsulation layer at least partially encapsulating the first semiconductor chip and the second semiconductor chip, the encapsulation layer having a first side and a second side opposite the first side, the second side facing in a same direction as the second side of the second semiconductor chip; and
an interconnect structure disposed at least partially within the encapsulation layer and electrically coupled to at least one of the first and second semiconductor chips, wherein the interconnect structure extends to the second side of the encapsulation layer.

2. The chip arrangement of claim 1, further comprising:
at least one electrical connector disposed between the first side of the first semiconductor chip and the first side of the second semiconductor chip, the at least one electrical connector electrically coupling the first semiconductor chip to the second semiconductor chip.

3. The chip arrangement of claim 1, wherein the interconnect structure extends from the first side of the first semiconductor chip to the second side of the encapsulation layer; or
wherein the interconnect structure further extends over the second side of the second semiconductor chip; or
further comprising:
at least one electrical connector disposed at the second side of the encapsulation layer and electrically coupled to the interconnect structure; or
wherein the interconnect structure is electrically coupled to the first semiconductor chip and the second semiconductor chip.

4. The chip arrangement of claim 2, wherein the interconnect structure is electrically coupled to the at least one electrical connector disposed between the first side of the first semiconductor chip and the first side of the second semiconductor chip.

5. The chip arrangement of claim 1, wherein the interconnect structure comprises at least one metal pillar extending from the first side of the first semiconductor chip layer to the second side of the encapsulation layer.

6. The chip arrangement of claim 5, wherein the at least one metal pillar is disposed laterally adjacent to the second semiconductor chip; or
wherein the interconnect structure further comprises a redistribution layer disposed at the first side of the first semiconductor chip and electrically coupled to the at least one metal pillar.

7. The chip arrangement of claim 1, wherein the first semiconductor chip is larger than the second semiconductor chip; or
wherein the second semiconductor chip is disposed laterally within a boundary of the first semiconductor chip; or wherein the second semiconductor chip has a thickness of less than or equal to about 100 µm; or
configured as an embedded wafer level ball grid array package.

8. The chip arrangement of claim 1, further comprising:
a third semiconductor chip disposed at at least one of the second side of the second semiconductor chip and the second side of the encapsulation layer, the third semiconductor chip having a first side and a second side opposite the first side, the second side of the third semiconductor chip facing in the same direction as the second side of the second semiconductor chip and the second side of the encapsulation layer.

9. The chip arrangement of claim 8, wherein the third semiconductor chip is electrically coupled to the interconnect structure; optionally further comprising:
at least one electrical connector disposed over the second side of the encapsulation layer laterally adjacent to the third semiconductor chip and electrically coupled to the interconnect structure, wherein the at least one electrical connector protrudes farther from the second side of the encapsulation layer than a distance between the second side of the third semiconductor chip and the second side of the encapsulation layer.

10. The chip arrangement of claim 1, configured as a chip package.

11. The chip arrangement of claim 10, further comprising:
at least one through-via extending through the encapsulation layer, and
a metallization layer disposed at least partially over the first side of the encapsulation layer and electrically coupled to the at least one through-via,
for electrically coupling at least one additional chip package.

12. The chip arrangement of claim 11, wherein the at least one through-via extends from the second side of the encapsulation layer to the first side of the encapsulation layer; or
further comprising at least one additional chip package disposed over at least one of the first side of the encapsulation layer and the second side of the first semiconductor chip, and electrically coupled to the metallization layer.

13. A method for manufacturing a chip arrangement, the method comprising:
providing a first semiconductor chip having a first side and a second side opposite the first side; disposing a second semiconductor chip over the first side of the first semiconductor chip, the second semiconductor chip having a first side and a second side opposite the first side, the first side of the second semiconductor chip facing the first side of the first semiconductor chip, wherein the second semiconductor chip is electrically coupled to the first semiconductor chip;
forming an encapsulation layer to at least partially encapsulate the first and second semiconductor chips, the encapsulation layer having a first side and a second side opposite the first side, the second side of the encapsulation layer facing in a same direction as the second side of the second semiconductor chip; and
forming an interconnect structure at least partially within the encapsulation layer, wherein the interconnect structure is electrically coupled to at least one of the first and second semiconductor chips and extends to the second side of the encapsulation layer.

14. The method of claim 13, wherein the first semiconductor chip has at least one electrically conductive contact at a first side of the first semiconductor chip,
wherein forming the interconnect structure at least partially within the encapsulation layer comprises:
forming at least one metal pillar over the first side of the first semiconductor chip electrically coupled to the at least one electrically conductive contact of the first semiconductor chip, before
disposing the second semiconductor chip over the first side of the first semiconductor chip; and forming the encapsulation layer after disposing the second semiconductor chip over the first side of the
first semiconductor chip to at least partially encapsulate the first and second semiconductor chips and the at least one metal pillar; or
wherein disposing the second semiconductor chip over the first side of the first semiconductor chip comprises attaching the first side of the second semiconductor to the first side of the first semiconductor chip.

15. The method of claim 13, further comprising:
thinning the second semiconductor chip after forming the encapsulation layer; optionally wherein thinning the second semiconductor chip comprises grinding the second semiconductor chip and the encapsulation layer after forming the encapsulation layer.
